(19) Europäisches Patentamt / European Patent Office / Office européen des brevets

(11) **EP 2 804 271 B1**

(12) **FASCICULE DE BREVET EUROPEEN**

(45) Date de publication et mention
de la délivrance du brevet:
**28.02.2018 Bulletin 2018/09**

(51) Int Cl.:
*H01S 5/022* [(2006.01)]    *H01S 5/06* [(2006.01)]
*H01S 5/34* [(2006.01)]

(21) Numéro de dépôt: **14168454.8**

(22) Date de dépôt: **15.05.2014**

(54) **Source optique paramétrique sur puce pompée électriquement**

Elektrisch angetriebene optische parametrische Quelle auf einem Chip

Electrically pumped parametric optical source on a chip

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.05.2013 FR 1354413**

(43) Date de publication de la demande:
**19.11.2014 Bulletin 2014/47**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **Gerard, Jean-Michel
  38410 Saint Martin d'Uriage (FR)**
• **Leo, Giuseppe
  94120 Fontenay Sous Bois (FR)**
• **Andronico, Alessio
  94220 Charenton le Pont (FR)**
• **Ducci, Sara
  75012 Paris (FR)**

(74) Mandataire: **Lebkiri, Alexandre
Cabinet Camus Lebkiri
25, Rue de Maubeuge
75009 Paris (FR)**

(56) Documents cités:
**EP-A1- 1 089 405    FR-A1- 2 894 396**

• **CUNZHU TONG ET AL: "Characteristics of
Edge-Emitting Bragg Reflection Waveguide
Lasers", IEEE JOURNAL OF QUANTUM
ELECTRONICS, IEEE SERVICE CENTER,
PISCATAWAY, NJ, USA, vol. 46, no. 11, 1
novembre 2010 (2010-11-01), pages 1605-1610,
XP011317140, ISSN: 0018-9197**
• **PAYAM ABOLGHASEM ET AL: "Single-sided
Bragg reflection waveguides with multilayer core
for monolithic semiconductor parametric
devices", JOURNAL OF THE OPTICAL SOCIETY
OF AMERICA B, vol. 29, no. 6, 1 juin 2012
(2012-06-01), page 1367, XP055101794, ISSN:
0740-3224, DOI: 10.1364/JOSAB.29.001367**
• **BIJLANI B J ET AL: "Intracavity Parametric
Fluorescence in Diode Lasers", CLEO: 2011 -
LASER SCIENCE TO PHOTONIC APPLICATIONS
IEEE PISCATAWAY, NJ, USA, 2011, page 2 pp.,
XP002720211,**

**Description**

**DOMAINE TECHNIQUE DE L'INVENTION**

Le domaine technique de l'invention est celui des sources optiques cohérentes compactes et accordables en longueur d'onde.

La présente invention concerne une source optique paramétrique sur puce pompée électriquement et en particulier une diode laser semiconductrice capable d'émettre par génération paramétrique intracavité un rayonnement infrarouge accordable.

**ARRIERE-PLAN TECHNOLOGIQUE DE L'INVENTION**

Le domaine du spectre électromagnétique compris dans le proche infrarouge, dans la gamme de longueur d'onde comprise entre 1 et 3 $\mu$m, joue un rôle clef dans le contexte socio-économique actuel. En effet, il est au coeur des communications sur fibre optique et très utilisé dans de nombreuses applications liées à la détection de gaz polluants et au domaine de la sécurité.

On cherche de ce fait depuis de nombreuses années à disposer de sources optiques accordables dans cette gamme de longueur d'onde, et à pompage électrique pour garantir compacité et commodité d'emploi. Les sources semiconductrices disponibles à ce jour (diodes lasers, lasers à cascade quantique) présentent une accordabilité très limitée, basée sur un contrôle en température et/ou courant d'injection. Par exemple, l'accordabilité en température sans saut de mode d'un laser à gain distribué DFB (« distributed feedback laser » en anglais) est d'environ 6 nm dans le cas d'une diode In-GaAsP dans la bande télécom (pour une excursion en température $\Delta T$ d'environ 50°C), d'environ 3 nm dans la cas d'une diode InGaAsSb autour de 2 $\mu$m (pour une excursion en température $\Delta T$ d'environ 13°C), et d'environ 20 nm pour un laser à cascade InGaAs/AlAsSb autour de 3,35 $\mu$m (pour une excursion en température $\Delta T$ d'environ 90°C).

Une approche alternative pour obtenir une source brillante et accordable de lumière cohérente consiste à réaliser un Oscillateur Paramétrique Optique (OPO) pompé électriquement. Le principe de base d'un tel dispositif est de réaliser, au sein d'un composant laser à semiconducteur émettant à une pulsation de pompe $\omega p$, la génération paramétrique de rayonnement à deux pulsations complémentaires, une pulsation signal $\omega s$ et une pulsation complémentaire $\omega c$, vérifiant l'équation : $\omega s + \omega c = \omega p$, en exploitant les propriétés non-linéaires du matériau semiconducteur constituant le laser.

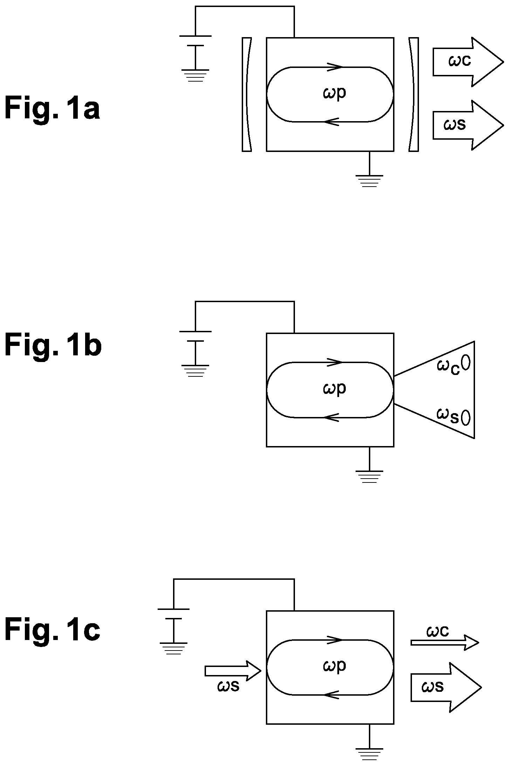

Si une cavité est définie pour le rayonnement à la pulsation signal $\omega s$ et/ou à la pulsation complémentaire $\omega c$, le composant est à proprement parler un OPO. Pour une certaine puissance de pompe à la pulsation de pompe $\omega p$, on atteint le seuil de l'OPO, au-dessus duquel le composant émet deux faisceaux de lumière cohérente aux pulsations signal $\omega s$ et complémentaire $\omega c$. Nous appellerons dans la suite ce composant « laser-OPO ». Son principe de fonctionnement est illustré à la figure 1a.

Si on ne définit pas de cavité à la pulsation signal $\omega s$ et/ou à la pulsation complémentaire $\omega c$, ou si l'on se place en dessous du seuil de l'OPO, le composant émet par fluorescence paramétrique des paires de photons, aux pulsations signal $\omega s$ et complémentaire $\omega c$, émis simultanément et qui présentent de très fortes corrélations quantiques. Il est bien connu que ces paires de photons dits « jumeaux » présentent un grand intérêt dans le domaine des communications quantiques, le traitement quantique de l'information et la métrologie. Dans la suite, nous appellerons ce composant « source de photons jumeaux pompée électriquement ». Son principe de fonctionnement est illustré à la figure 1b. D'autres fonctions peuvent être réalisées à partir d'une structure de laser-OPO, en exploitant la génération paramétrique. Considérons par exemple un laser-OPO au-dessus du seuil laser à la pulsation de pompe $\omega p$, mais sous le seuil de l'OPO. Si on injecte optiquement un faisceau cohérent à la pulsation signal $\omega s$ dans le composant, il est possible de déclencher l'oscillation paramétrique optique, et d'obtenir un faisceau cohérent amplifié à la pulsation signal ws, ainsi qu'un faisceau cohérent à la pulsation complémentaire $\omega c$. Ce composant agit alors comme un amplificateur à la pulsation signal $\omega s$, ainsi que comme un translateur de pulsation, de la pulsation signal $\omega s$ vers la pulsation complémentaire $\omega c$. Son principe de fonctionnement est illustré à la figure 1c.

La réalisation d'un oscillateur paramétrique optique sur puce pompé électriquement a cependant jusqu'ici buté sur une difficulté majeure : l'obtention de la condition « d'accord de phase » entre les différents faisceaux. Pour que la génération paramétrique soit efficace, il faut en effet assurer l'annulation du désaccord de phase entre les modes optiques impliqués. Dans le cas de la fluorescence paramétrique à la dégénérescence, où un photon de pompe à la pulsation de pompe $\omega p$ se scinde en deux photons de même énergie, un photon signal à la pulsation signal $\omega s$ et un photon complémentaire à la pulsation complémentaire $\omega c$ selon l'équation $\omega s = \omega c = \omega p/2$, cela correspond à la condition : $n(\omega p) = n(\omega p/2)$, où $n(\omega)$ désigne l'indice de réfraction d'un matériau à la pulsation $\omega$.

Dans le cas général, le triplet de pulsations doit satisfaire les deux conditions suivantes :

- Conservation de l'énergie :

$$\omega p = \omega s + \omega c$$

- Accord de phase :

$$\omega p * n(\omega p) = \omega s * n(\omega s) + \omega c * n(\omega c)$$

Dans un milieu massif, l'accord de phase est empêché par la dispersion chromatique (l'indice de réfraction croît en fonction de la pulsation). L'accord de phase ne peut être atteint que dans des matériaux particuliers présentant une biréfringence optique, laquelle permet d'atteindre l'égalité entre indices de deux modes de polarisations différentes. Cet accord de phase biréfringent n'est pas possible dans des cristaux massifs optiquement isotropes tels que l'arséniure de gallium GaAs.

Le confinement des faisceaux de pompe, signal et complémentaire par un guide d'onde offre de nouvelles possibilités pour réaliser la condition d'accord de phase. En effet, la propagation des différents modes guidés est caractérisée par un indice effectif spécifique pour chaque mode, et l'indice effectif d'un mode d'ordre élevé est plus faible (à une pulsation $\omega$ donnée) que celui du mode guidé fondamental. Il devient alors possible de compenser l'effet de dispersion chromatique par cet effet de dispersion modale. En confinant les faisceaux, les guides d'ondes assurent aussi un meilleur recouvrement des trois ondes et une génération paramétrique plus efficace.

En sus, les guides d'ondes de semiconducteurs III-V, largement utilisés en optoélectronique, présentent d'importants atouts additionnels :

- les technologies de micro- et nanoélectronique permettent une ingénierie très poussée des hétérostructures optiques et une très grande perfection des structures réalisées ;
- la non-linéarité quadratique non résonante de ces structures peut prendre des valeurs très élevées, en raison de la valeur élevée du coefficient non-linéaire du GaAs dans le proche infrarouge ($d_{14} = 100$ pm/V) ;
- les matériaux semiconducteurs III-V ont de bonnes propriétés thermiques et mécaniques et peuvent supporter des intensités optiques très élevées.

Dans ce contexte, A. Helmy propose dans le document US2007/0104443 une méthode pour obtenir l'accord de phase entre différentes ondes dans un guide d'onde. Selon cette méthode, l'accord de phase est obtenu en combinant le phénomène de réflexion totale interne TIR (« Total Internal Reflection » en anglais) avec deux miroirs de Bragg distribués DBR (« Distributed Bragg Reflector » en anglais). Dans la suite de ce document, on appelle la méthode proposée dans le document US2007/0104443 « méthode DBR-TIR ».

D'autres dispositifs sont divulgués dans les articles de C.Tong: "Characteristics of Edge-Emitting Bragg Reflection Waveguide Lasers", IEEE Journal of Quantum Electronics, vol. 46, no. 11, 1 novembre 2010, pages 1605-1610 et P. Abolghasem: "Single-sided Bragg reflection waveguides with multilayer core for monolithic semiconductor parametric devices", Journal of the optical society of America B, vol. 29, no. 6, 1 juin 2012, page 1367.

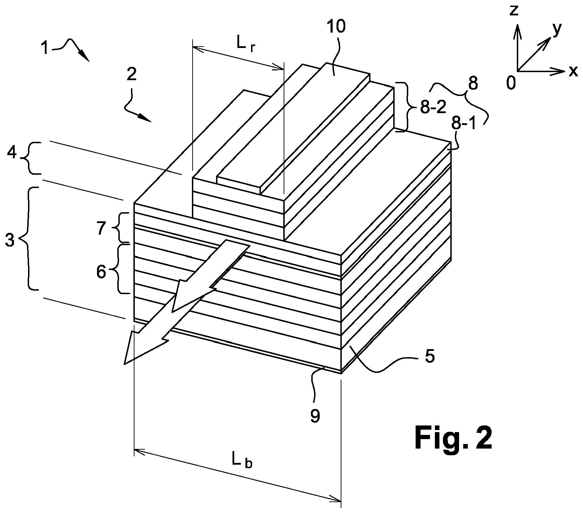

Jusqu'à présent, la méthode DBR-TIR est la seule qui ait permis d'observer expérimentalement une fluorescence paramétrique par génération intra-cavité dans une diode laser à puits quantiques. La figure 2 illustre ainsi une diode laser à fluorescence paramétrique 1, présentée dans le document « Intracavity Parametric Fluorescence in Diode Lasers » de B. J. Biljani et al. (actes de la conférence CLEO 2011, article PDPA3). La diode laser à fluorescence paramétrique 1 comporte une hétérostructure semiconductrice 2 présentant une base 3 et un ruban 4.

La base 3 de l'hétérostructure semiconductrice 2 s'étend suivant un plan de référence Oxy. La base 3 possède une largeur Lb mesurée suivant l'axe Ox. La base 3 comporte les couches suivantes, empilées suivant un axe Oz :

- un substrat semiconducteur 5 en GaAs ;
- un premier super-réseau 6 s'étendant sur le substrat semiconducteur 5. Le premier super-réseau 6 est formé par un empilement périodique de sous-couches de GaAs et de GaAlAs, agissant comme un réflecteur de Bragg à la longueur d'onde de pompe de 1 $\mu$m ;
- une couche active 7 en GaAlAs s'étendant sur le premier super-réseau 6 et comportant de multiples puits quantiques, les multiples puits quantiques assurant l'émission d'une onde de pompe à une longueur d'onde de pompe de 1 $\mu$m ;
- une première partie 8-1 d'un deuxième super-réseau 8, la première partie 8-1 s'étendant sur la couche active 7, le deuxième super-réseau 8 comportant un empilement périodique de sous-couches de GaAs et de GaAlAs, agissant comme un réflecteur de Bragg à la longueur d'onde de pompe de 1 $\mu$m.

Le ruban 4 s'étend sur la base 3 de l'hétérostructure semiconductrice 2. Le ruban 4 possède une largeur Lr, mesurée suivant l'axe Ox, inférieure à la largeur Lb de la base 3. Le ruban 4 comporte une deuxième partie 8-2 du deuxième super-réseau 8.

Le premier super-réseau 6 et le deuxième super-réseau 8 assurent le confinement vertical de l'onde de pompe en agissant comme des réflecteurs de Bragg à la longueur d'onde de pompe. Pour les longueurs d'onde signal et complémentaire, l'effet « réflecteur de Bragg » est absent et le confinement vertical des ondes signal et complémentaire est assuré par réflexion totale interne. Pour cela, les premier et deuxième super-réseaux 6 et 8 possèdent un indice de réfraction moyen plus petit que l'indice de réfraction moyen de la couche active 7.

La diode laser à fluorescence paramétrique 1 comporte en outre :

- un premier contact électrique 9 s'étendant sous le substrat 5 de la base 3 ;
- un deuxième contact électrique 10 s'étendant sur le ruban 4.

Un tel dispositif présente cependant des limitations majeures :

- il possède une condition d'accord de phase extrêmement critique à obtenir ;
- il ne permet qu'une faible accordabilité en température des longueurs d'ondes du signal et du complémentaire ;
- il ne peut pas atteindre des niveaux de puissance significatifs, c'est-à-dire de l'ordre de la centaine de nW, pour les longueurs d'ondes du signal et du complémentaire.

Cette structure n'a notamment pas permis d'atteindre le seuil d'oscillation de l'OPO. Toutes ces limitations entravent fortement les perspectives d'un oscillateur paramétrique optique sur puce pompé électriquement.

Les deux premières difficultés listées ci-dessus sont liées à la nécessité de disposer de paramètres libres facilement ajustables pour satisfaire d'une part la condition d'accord de phase, et pour obtenir d'autre part une accordabilité en fréquence du composant. Considérons à titre d'exemple un fonctionnement de l'OPO à la dégénérescence ($\omega s = \omega c = \omega p/2$). La résolution de l'équation d'accord de phase donne comme solution, s'il en existe une, une pulsation $\omega p^{AP}$. Pour que le laser-OPO fonctionne, il faut bien évidemment que cette pulsation corresponde à celle du mode laser. C'est là une difficulté réelle, car la bande d'accord de phase est très étroite, typiquement de l'ordre de 1 nanomètre pour des structures en GaAs/GaAlAs.

Ce point a des conséquences pratiques importantes, car le procédé de fabrication d'un laser-OPO commence par une croissance épitaxiale de l'hétérostructure semiconductrice contenant le milieu actif. Après cette première étape de croissance, la position spectrale de la courbe de gain pour une température donnée est fixée, ainsi que la position de son maximum, au voisinage duquel on trouvera le mode laser. On doit donc disposer d'un paramètre de contrôle qui permette d'assurer l'égalité entre la pulsation de pompe du mode laser $\omega p$ et la pulsation d'accord de phase $\omega p^{AP}$.

On peut utiliser à cet effet la température T comme paramètre ajustable, car celle-ci agit différemment sur la courbe de gain du laser (et donc sur la pulsation de pompe $\omega p$) et sur la pulsation d'accord de phase $\omega p^{AP}$. En pratique, un tel composant paramétrique est généralement installé sur une embase à température contrôlée, qui permet un contrôle fin de la condition d'accord de phase. Cette embase permet par exemple de compenser l'échauffement du composant laser en fonctionnement, qui peut potentiellement faire perdre l'accord de phase. La température peut aussi être employée pour conférer une certaine accordabilité spectrale au composant. En effet, partant d'un point de fonctionnement possible à une température T, défini par un triplet de pulsations ($\omega p(T)$, $\omega s(T)$, $\omega c(T)$), avec :

- wp(T) la pulsation laser de pompe à la température T ;
- $\omega s(T)$ la pulsation signal à la température T ;
- $\omega c(T)$ la pulsation complémentaire à la température T ;

un changement de la température T modifie la pulsation laser de pompe ainsi que les indices effectifs des trois modes. De ce fait, l'accord de phase sera obtenu pour de nouvelles pulsations signal et complémentaire. La température est donc un paramètre très utile pour le contrôle fin du laser-OPO, mais elle ne permet de corriger que de faibles déviations par rapport à l'accord de phase.

A contrario, le fait de réaliser le guidage optique à l'intérieur d'un ruban réalisé par gravure profonde fournit un degré de liberté très efficace pour jouer sur l'accord de phase. On entend par « ruban réalisé par gravure profonde » une structure pour laquelle les modes sont confinés latéralement par les flancs gravés du ruban. Dans une diode laser, cela veut dire que le milieu actif se trouve dans le ruban. En effet, la condition d'accord de phase peut être très bien contrôlée par une simple variation de la largeur du ruban profondément gravé, si celui-ci est suffisamment étroit, de l'ordre de quelques micromètres de large typiquement. En outre, la largeur du ruban est un paramètre qu'il est facile d'ajuster lors de la fabrication du composant, et que l'on sait définir avec une grande précision.

Dans le cas d'une diode laser à puits quantiques cependant, la recombinaison des paires électron-trou sur les surfaces latérales du ruban gravé a un effet très pénalisant sur le fonctionnement du composant. En raison de cette contrainte, la largeur d'un ruban est toujours, en pratique, au moins de plusieurs dizaines de micromètres de large. De fait, la diode laser à fluorescence paramétrique illustrée à la figure 2 met en oeuvre un ruban 4 gravé peu profond : la couche active 7 ne se trouve pas dans le ruban 4 mais dans la base 3. La gravure peu profonde suffit à localiser latéralement les modes, mais elle n'a qu'un effet très faible sur les indices effectifs des trois modes et par conséquent, sur la pulsation d'accord de phase à la dégénérescence $\omega p^{AP}$. Pour être plus précis, une variation de la largeur de ruban de 3 à 5 $\mu m$ ne permet pas de décaler $\omega p^{AP}$ de plus de 2 nm dans le cas de la structure étudiée par Biljani et al, alors que le décalage possible pourrait dépasser 20 nm avec la même structure, si une gravure profonde du ruban était possible.

Cette faible aptitude à jouer sur $\omega p^{AP}$ est aussi à l'origine de la deuxième difficulté précédemment évoquée : même si on trouve un point d'accord de phase, on ne pourra pas accorder en température le processus paramétrique, et par exemple changer la pulsation signal $\omega s$ et la pulsation complémentaire $\omega c$ tout en gardant constante leur somme, car la température modifie la pulsation de pompe $\omega p$. Utiliser le courant injecté dans le laser comme variable d'ajustement n'est pas non plus une bonne idée, pour au moins deux raisons :

a) les variables I et T sont liées ;

b) on souhaite que la puissance émise par un dispositif photonique puisse être modifiée indépendamment de sa longueur d'onde.

La troisième difficulté est liée à la grande résistance série du dispositif expérimental mis en oeuvre, représenté à la figure 2. Cette grande résistance série est elle-même due aux discontinuités des bandes dans les bi-couches qui constituent les miroirs de Bragg distribués DBR, ainsi qu'aux épaisseurs de ces derniers. Une variante de ce dispositif expérimental consiste à remplacer le miroir de Bragg distribué supérieur par une gaine de confinement par réflexion totale interne. Une telle modification permet certes de diviser la résistance série du composant par 2 mais n'élimine pas complètement le problème. Dans la suite de ce document, on désigne cette variante qui combine un seul réflecteur de Bragg distribué avec le phénomène de réflexion totale interne par l'acronyme « SS-BRW ».

**DESCRIPTION GENERALE DE L'INVENTION**

L'invention offre une solution aux problèmes évoqués précédemment, en permettant de réaliser un oscillateur paramétrique optique sur puce pompé électriquement. Une structure conforme à l'invention peut notamment, selon ses différents modes de fonctionnement, être utilisée comme laser-OPO, comme source de photons jumeaux ou comme amplificateur paramétrique optique à la pulsation signal et translateur de pulsation, de la pulsation signal vers la pulsation complémentaire.

Pour ce faire, l'invention propose d'employer comme milieu de gain un ou plusieurs plans de boîtes quantiques en lieu et place de puits quantiques. Le piégeage des paires électron-trou dans les boîtes quantiques limite en effet leur diffusion latérale. Il devient alors possible de réaliser des lasers à ruban étroit de quelques micromètres de large et à gravure profonde, c'est-à-dire comportant le milieu de gain, sans que leurs performances ne soient pénalisées par la recombinaison non-radiative des porteurs sur les flancs gravés du ruban. Cette modification majeure permet de résoudre les trois problèmes mentionnés ci-dessus, dans le contexte de la fabrication d'un oscillateur paramétrique optique.

L'invention concerne donc essentiellement une source laser accordable pompée électriquement comportant :

- une première couche de confinement optique s'étendant suivant un plan de référence Oxy et formant un réflecteur de Bragg distribué pour une onde de pompe à une longueur d'onde de pompe ;
- une couche active en matériau semiconducteur non linéaire s'étendant sur la première couche de confinement optique, l'indice de réfraction moyen de la couche active étant supérieur à l'indice de réfraction moyen de la première couche de confinement optique ;

- une deuxième couche de confinement optique s'étendant sur la couche active, l'indice de réfraction moyen de la deuxième couche de confinement optique étant inférieur à l'indice de réfraction moyen de la couche active ; ladite source laser comportant :
- une base ayant une première largeur suivant un axe Ox ;
- un ruban s'étendant sur la base, ledit ruban ayant une deuxième largeur suivant un axe Ox inférieure à ladite première largeur ;

la deuxième largeur étant inférieure à 10 $\mu$m, la couche active comprenant au moins un plan de boîtes quantiques aptes à émettre une onde de pompe à une longueur d'onde de pompe et le ruban comportant au moins :

- la partie de la couche active comprenant le plan de boîtes quantiques ;
- la deuxième couche de confinement optique ;

ledit ruban permettant l'émission, par conversion paramétrique à partir de l'onde de pompe, de deux ondes, dites respectivement « onde signal » et « onde complémentaire », la deuxième largeur étant choisie pour assurer l'accord de phase entre l'onde de pompe, l'onde signal et l'onde complémentaire.

Grâce à la mise en oeuvre d'un milieu de gain comportant des boîtes quantiques et d'un ruban étroit comportant au moins la deuxième couche de confinement optique et la région active, l'invention améliore considérablement le confinement optique du mode laser (mode de pompe de l'oscillateur paramétrique optique) ainsi que des modes de signal et de complémentaire. On entend par « ruban étroit » un ruban dont la largeur est inférieure à 10 $\mu$m. On entend par « indice de réfraction moyen » la valeur moyenne, dans un volume donné, d'un indice de réfraction. Tous les indices de réfraction sont calculés à une longueur d'onde double de la longueur d'onde de pompe. Par ailleurs, dans une structure conforme à l'invention, les indices effectifs deviennent beaucoup plus sensibles à la largeur du ruban. Tout cela se traduit par une réduction du courant laser, par une augmentation de la puissance de signal et de complémentaire, par une condition d'accord de phase beaucoup plus facile à trouver et par une accordabilité accrue en longueur d'onde. Le fait que la couche active se trouve dans le ruban étroit ouvre en outre la possibilité de placer le contact inférieur en face avant de la base, avec injection latérale des porteurs.

Outre les caractéristiques qui viennent d'être évoquées dans le paragraphe précédent, la source laser selon l'invention peut présenter une ou plusieurs caractéristiques complémentaires parmi les suivantes, considérées individuellement ou selon toutes les combinaisons techniquement possibles :

Dans le plan de boîtes quantiques, la densité des boîtes quantiques est comprise entre 1 boîte/$\mu$m$^2$ et 1000 boîtes/$\mu$m$^2$. Afin d'atteindre le seuil d'oscillation du laser-OPO (illustré à la figure 1a) ou d'augmenter les puissances de signal et complémentaire d'une source de photons jumeaux (illustrée à la figure 1b), d'un amplificateur paramétrique optique ou d'un translateur de fréquence (illustrés à la figure 1c), cette densité des boîtes quantiques est avantageusement comprise entre 100 boîtes/$\mu$m$^2$ et 1000 boîtes/$\mu$m$^2$.

Lorsque la couche active comprend plusieurs plans de boîtes quantiques, l'espacement entre deux plans de boîtes quantiques consécutifs est compris entre 10 nm et 40 nm. Avantageusement, l'espacement entre deux plans de boîtes quantiques consécutifs est de l'ordre de 20 nm.

Le ruban peut avantageusement comporter toute la couche active afin d'améliorer le facteur de confinement du mode de pompe dans la région active.

Le ruban peut avantageusement comporter une partie de la première couche de confinement optique afin d'améliorer le facteur de confinement du mode de pompe dans la région active.

La source laser a une longueur suivant un axe Oy perpendiculaire à l'axe Ox, comprise entre 100 $\mu$m et 5 mm. Ainsi, selon les pertes des modes de pompe, de signal, de complémentaire, la longueur sera avantageusement ajustée pour optimiser le fonctionnement du laser de pompe et l'efficacité de conversion de fréquence.

La deuxième couche de confinement optique forme avantageusement un réflecteur de Bragg distribué pour l'onde de pompe à la longueur d'onde de pompe. Ainsi, la deuxième couche de confinement optique contribue au confinement vertical de l'onde de pompe à la longueur d'onde de pompe.

Dans un mode de réalisation ciblant la réalisation d'une source laser conforme à l'invention et fonctionnant en oscillateur paramétrique optique, le ruban comporte un premier miroir diélectrique sur sa première facette de sortie et un deuxième miroir diélectrique sur sa deuxième facette de sortie afin d'assurer la réflexion de l'onde signal et/ou de l'onde complémentaire et/ou de l'onde de pompe. Ces miroirs diélectriques réduisent avantageusement les pertes optiques aux longueurs d'onde de signal et/ou de complémentaire et abaissent le seuil de l'oscillateur paramétrique optique.

Dans un autre mode de réalisation ciblant la réalisation d'une source laser conforme à l'invention et fonctionnant en source de photons jumeaux, le ruban comporte, pour l'onde signal et l'onde complémentaire, une couche optique de faible réflectivité sur sa première facette de sortie et une couche optique de haute réflectivité sur sa deuxième facette de sortie. La couche optique de faible réflectivité sur la première facette de sortie facilite avantageusement l'extraction des paires de photons jumeaux.

La source laser est pompée électriquement pour garantir compacité et commodité d'emploi.

Une source laser conforme à l'invention comporte :

- la base comporte une face supérieure, sur laquelle repose le ruban, et une face inférieure,
- le ruban comporte une face inférieure au contact de la face supérieure de la base et une face supérieure.

Dans un premier mode de réalisation de l'invention, la source laser comporte :

- un premier contact électrique placé sur la face supérieure du ruban ;
- un deuxième contact électrique placé sur la face inférieure de la base.

Selon ce premier mode de réalisation de l'invention :

- la source laser est dopée avec un premier type de dopage à partir de la face inférieure de la base sur laquelle est placé le deuxième contact électrique et jusqu'à la couche active, ainsi qu'éventuellement dans une partie de la couche active adjacente à la première couche de confinement optique, et au maximum jusqu'au plan de boîtes quantiques, le plan de boîtes quantiques inclus ;
- la source laser est dopée avec un deuxième type de dopage opposé au premier type de dopage à partir de la face supérieure du ruban sur laquelle est placé le premier contact électrique, dans toute la deuxième couche de confinement optique et jusqu'à la couche active, ainsi qu'éventuellement dans une partie de la couche active adjacente à la deuxième couche de confinement optique, et au maximum jusqu'au plan de boîtes quantiques, le plan de boîtes quantiques inclus.

Ainsi, on favorise avantageusement la conduction électrique par un type de porteur d'un côté de la couche active, et par l'autre type de porteur de l'autre côté de la couche active.

Dans un deuxième mode de réalisation de l'invention, la source laser comporte :

- un premier contact électrique placé sur la face supérieure du ruban ;
- un deuxième contact électrique placé sur une partie de la face supérieure de la sous-couche supérieure de la base.

Ce deuxième mode de réalisation permet avantageusement d'éviter le transport électronique à travers la totalité de la première couche de confinement optique. Cet avantage devient encore plus considérable pour une structure dont la deuxième couche de confinement optique ne comporte pas de miroir de Bragg distribué. Dans une telle structure, le seul miroir de Bragg distribué - situé dans la première couche de confinement optique - n'est plus entièrement traversé par le courant, tout en jouant un rôle clé pour le confinement du mode de pompe et pour l'obtention de l'accord de phase.

Selon ce deuxième mode de réalisation de l'invention :

- la source laser est dopée avec un premier type de dopage au moins à partir de la sous-couche supérieure de la base sur laquelle est placé le deuxième contact et jusqu'à la couche active.
- la deuxième couche de confinement optique est dopée avec un deuxième type de dopage opposé au premier type de dopage.

Ainsi, on favorise avantageusement la conduction électrique par un type de porteur d'un côté de la couche active, et par l'autre type de porteur de l'autre côté de la couche active.

Selon ces premier et deuxième modes de réalisation et pour une structure à deux miroirs de Bragg, on injecte préférentiellement :

- les électrons par le premier contact électrique ;
- les trous par le deuxième contact électrique.

Selon ces premier et deuxième modes de réalisation et pour une structure à un seul miroir de Bragg dans la première couche de confinement optique, on injecte préférentiellement :

- les trous par le premier contact électrique ;
- les électrons par le deuxième contact électrique.

Ainsi, dans tous les cas, on abaisse avantageusement la résistance série du dispositif car le transport de trous à travers un miroir de Bragg est plus difficile que celui des électrons, du fait de leur masse effective plus élevée.

Une source laser selon l'invention, selon l'un quelconque des modes de réalisation, repose avantageusement sur une embase permettant de contrôler sa température. En effet, la température est un paramètre ajustable qui agit différemment sur la courbe de gain du laser, donc sur la pulsation de pompe, et sur la pulsation d'accord de phase. Une telle embase est très utile pour le contrôle fin de la source laser.

La source laser émet avantageusement un rayonnement dans une gamme de longueur d'onde comprise entre 1 μm et 3 μm. La gamme de longueur d'onde comprise entre 1 et 3 μm est en effet au coeur des communications sur fibre optique et est très utilisée dans de nombreuses applications liées à la détection de gaz polluants et au domaine de la sécurité. Une source laser conforme à l'invention permet donc avantageusement de disposer d'une source optique accordable dans cette gamme de longueur d'onde.

Dans le cas où la source laser émet un rayonnement dans une gamme de longueur d'onde comprise entre 1 μm et 3 μm, l'onde de pompe est avantageusement émise par une couche active en GaAs comportant au moins un plan de boîtes quantiques d'InAs.

L'invention concerne également un procédé de fabrication d'une source laser comportant les étapes suivantes :

- croissance épitaxiale sur un substrat s'étendant suivant un plan de référence Oxy d'une hétérostructure semiconductrice comportant au moins les couches suivantes dans cet ordre à partir du substrat :

  • une couche tampon ;
  • une première couche de confinement optique formant un réflecteur de Bragg distribué pour une onde de pompe à une longueur d'onde de pompe ;
  • une couche active en matériau semiconducteur optiquement non linéaire, l'indice de réfraction moyen de la couche active étant supérieur à l'indice de réfraction moyen de la première couche de confinement optique, ladite couche active comportant au moins un plan de boîtes quantiques aptes à émettre l'onde de pompe à la longueur d'onde de pompe ;
  • une deuxième couche de confinement optique, l'indice de réfraction moyen de la deuxième couche de confinement optique étant inférieur à l'indice de réfraction moyen de la couche active ;

- gravure, suivant une direction Oz dans l'hétérostructure semiconductrice, au moins dans la deuxième couche de confinement optique et dans la partie de la couche active comprenant le plan de boîtes quantiques, d'un ruban, ledit ruban ayant une largeur inférieure à 10 μm.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1a représente schématiquement le fonctionnement d'un laser-OPO ;
- La figure 1b représente schématiquement le fonctionnement d'une source de photons jumeaux ;
- La figure 1c représente schématiquement le fonctionnement d'un amplificateur paramétrique optique à une pulsation signal ωs et d'un translateur de fréquence de la pulsation signal ωs à une pulsation complémentaire ωc ;

- La figure 2 représente schématiquement une diode laser à fluorescence paramétrique selon l'état de la technique ;
- La figure 3a représente schématiquement une source paramétrique selon un premier mode de réalisation de l'invention ;
- La figure 3b représente schématiquement une source paramétrique selon un deuxième mode de réalisation de l'invention ;
- La figure 4 représente schématiquement une coupe transverse d'une hétérostructure semiconductrice selon un mode de réalisation de l'invention ;
- La figure 5 représente des courbes d'accord de phase calculées pour une génération paramétrique à la dégénérescence au sein d'un dispositif selon l'invention ;
- La figure 6 représente des cartes transverses du champ électromagnétique associées aux modes de pompe, signal et complémentaire générés par un dispositif selon l'invention ;
- La figure 7 représente le profil vertical des premiers modes guidés à la longueur d'onde de pompe de 0,95 μm pour un dispositif selon l'invention ;
- La figure 8 est une représentation graphique de l'évolution des longueurs d'onde de l'onde signal et de l'onde complémentaire en fonction de la température dans un dispositif conforme à l'invention ;
- Les figures 9a à 9f illustrent différentes étapes d'un procédé de fabrication d'un dispositif conforme à l'invention.

## DESCRIPTION DETAILLEE D'AU MOINS UN MODE DE REALISATION DE L'INVENTION

Sauf précision contraire, un même élément apparaissant sur des figures différentes présente une référence unique.

Dans la présente description, nous décrivons en détail à titre d'exemple purement illustratif une structure de source paramétrique conforme à l'invention. Cette structure est conçue pour fonctionner en oscillateur paramétrique optique (OPO) avec une onde de pompe à une longueur d'onde de pompe de 0,95 μm, et en mode dégénéré, c'est-à-dire avec une longueur d'onde de signal et une longueur d'onde de complémentaire de 1,9 μm. La structure ici décrite permet d'obtenir une source laser compacte et accordable dans une gamme de longueur d'onde comprise entre 1 micromètre et 3 micromètres.

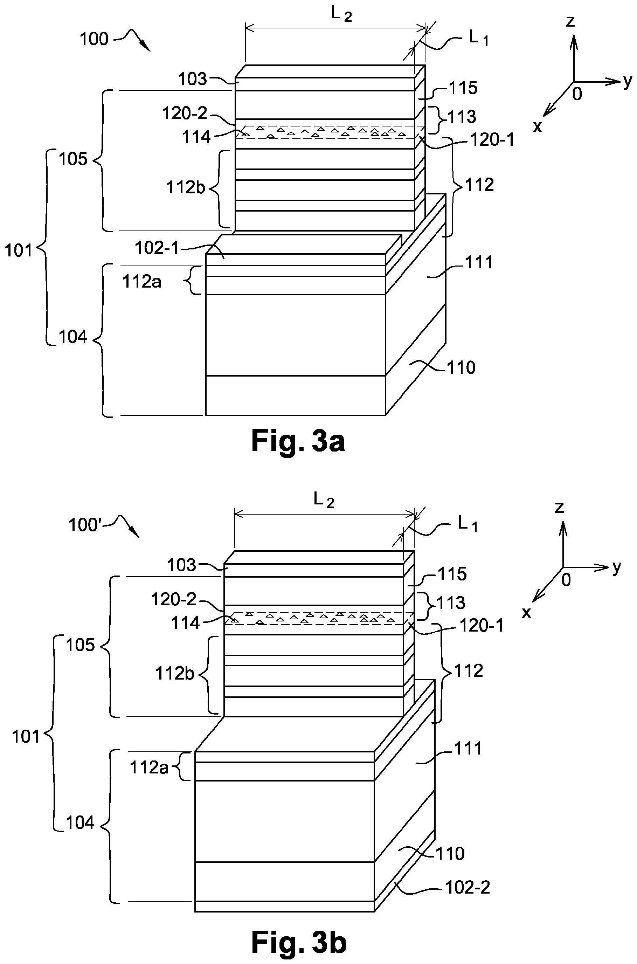

La figure 3a représente schématiquement une source laser 100 selon un premier mode de réalisation de l'invention.

La source laser 100 selon l'invention assure simultanément :

- la fonction de diode laser pour une onde de pompe à une pulsation de pompe ωp ;
- la fonction d'oscillateur paramétrique optique émettant, par conversion paramétrique à partir de l'onde de pompe à la pulsation de pompe ωp, une onde signal à la pulsation signal ωs et une onde complémentaire, dite également « idler », à la pulsation complémentaire ωc.

L'onde de pompe à la pulsation de pompe ωp est générée, au sein de la source laser 100, par un milieu actif comportant un ou plusieurs plans de boîtes quantiques semiconductrices.

La géométrie de la source laser 100 est celle d'une diode laser à émission par la tranche et à ruban défini par gravure profonde. Le confinement latéral des ondes de pompe, signal et complémentaire aux pulsations ωp, ωs et ωc est assuré par ce ruban. Le confinement vertical de l'onde de pompe à la pulsation ωp est assuré du côté du substrat par un réflecteur de Bragg distribué.

La source laser 100 comporte :

- une hétérostructure semiconductrice 101 ;
- un premier contact électrique 102-1 ;
- un deuxième contact électrique 103.

L'hétérostructure semiconductrice 101 comporte :

- une base 104 s'étendant suivant un plan Oxy de référence ;
- un ruban 105 s'étendant sur la base 104, le ruban 105 ayant une largeur L1 mesurée suivant un axe Ox de 3,5 μm et une longueur L2 mesurée suivant un axe Oy de l'ordre de 1 mm.

La base 104 comporte les couches suivantes, empilées suivant un axe Oz :

- un substrat semiconducteur 110 ;
- une couche tampon 111 s'étendant sur le substrat 110 ;
- une première partie 112a d'une première couche de confinement optique 112, la première partie 112a s'étendant sur la couche tampon 111.

Le ruban 105 comporte les couches suivantes, empilées suivant l'axe Oz :

- une deuxième partie 112b de la première couche de confinement optique 112 ;
- une couche active 113 comportant un plan 114 de boîtes quantiques, la couche active 113 s'étendant sur la deuxième partie 112b de la première couche de confinement optique 112 ;
- une deuxième couche de confinement optique 115 s'étendant sur la couche active 113.

La première couche de confinement optique 112 est formée par un premier empilement périodique de sous-couches constituant un miroir de Bragg distribué pour le mode de pompe à la pulsation de pompe ωp. Ainsi la première couche de confinement optique 112 contribue au confinement vertical de l'onde de pompe à la pulsation de pompe ωp. L'indice de réfraction moyen de la première couche de confinement optique 112 est inférieur à l'indice de réfraction moyen de la couche active 113. Ainsi la première couche de confinement optique 112 contribue au confinement vertical des ondes signal et complémentaires aux pulsations ωs et ωc par réflexion totale interne.

Dans l'exemple représenté, la première couche de confinement optique 112 se trouve à la fois dans la base 104, avec sa première partie 112a, et dans le ruban 105, avec sa deuxième partie 112b. Alternativement, la première couche de confinement optique peut se trouver entièrement dans la base 104, ou entièrement dans le ruban 104. Entre ces deux cas extrêmes, la répartition de l'empilement périodique de sous-couches entre les première et deuxième parties 112a et 112b appartenant respectivement à la base 104 et au ruban 105 peut varier.

Selon le premier mode de réalisation illustré à la figure 3a, la source laser 100 comporte un premier contact électrique 102-1 qui s'étend sur une partie de la surface supérieure de la base 104, c'est-à-dire dans l'exemple représenté sur une partie de la surface supérieure de la première partie 112a de la première couche de confinement optique 112.

Selon ce premier mode de réalisation, la première couche de confinement optique 112 est dopée, par exemple avec un dopage de type N :

- au moins dans sa deuxième partie 112b appartenant au ruban 105, sur laquelle repose la couche active 113,
- et dans une partie de sa première partie 112a appartenant à la base 104, sur une partie de laquelle repose le premier contact électrique 102-1.

La source laser 100 comporte en outre un deuxième contact électrique 103 qui s'étend sur la surface supérieure du ruban 105, c'est-à-dire sur la deuxième couche de confinement optique 115. La deuxième couche de confinement optique 115 est dopée et son type de dopage est opposé au type de dopage de la première couche de confinement optique 112. Si la première couche de confinement optique 112 possède un dopage de type N, alors la deuxième couche de confinement optique 115 est dopée P.

La deuxième couche de confinement optique 115 est une couche dont l'indice de réfraction moyen est inférieur à l'indice de réfraction moyen de la couche active 113. Ainsi la deuxième couche de confinement optique 115 contribue au confinement vertical des ondes signal et complémentaire aux pulsations ωs et ωc par réflexion totale interne. Selon une variante du premier mode de réalisation, la deuxième couche de confinement optique 115 peut contenir un deuxième empilement périodique de sous-couches constituant un miroir de Bragg distribué pour le mode de pompe à la pulsation de pompe ωp. Ainsi la deuxième couche de confinement optique 115 contribue au confinement vertical de l'onde de pompe à la pulsation de pompe ωp.

La couche active 114 du ruban 105 présente en outre une première facette de sortie 120-1 et une deuxième facette de sortie 120-2, s'étendant suivant un plan Oxz aux deux extrémités de la couche active 114. Les première et deuxième facettes de sortie 120-1 et 120-2 sont, dans l'exemple représenté, traitées par un multicouche diélectrique assurant une réflectivité de l'ordre de 90% pour le signal de pompe et pour le signal complémentaire.

La figure 3b représente schématiquement une source laser 100' selon un deuxième mode de réalisation de l'invention. Selon ce deuxième mode de réalisation, la source laser 100' comporte un premier contact électrique 102-2 qui s'étend sous la surface inférieure de la base 104.

Selon ce deuxième mode de réalisation où le premier contact électrique 102-2 est pris sous la surface inférieure de la base 104, le substrat 110, la couche tampon 111 et la première couche de confinement optique 112 sont dopés avec un dopage de même nature, par exemple un dopage de type N.

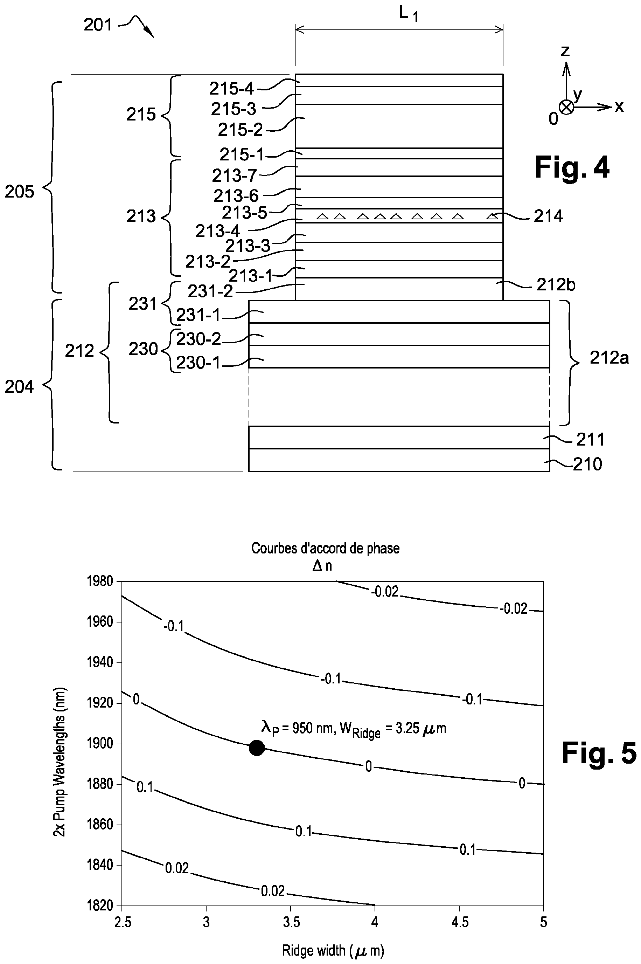

La figure 4 représente schématiquement une coupe suivant un plan Oxz d'une hétérostructure semiconductrice 201 selon l'invention. Nous détaillons ici la composition et l'épaisseur des couches de l'hétérostructure semiconductrice 201 ainsi que leur niveau de dopage le cas échéant. La structure représentée à la figure 4 est formée de matériaux de la famille des semiconducteurs III-V arséniures, pour lesquels les procédés technologiques sont très bien maîtrisés.

L'hétérostructure semiconductrice 201 comporte :

- une base 204 s'étendant suivant un plan Oxy de référence ;
- un ruban 205 s'étendant sur la base 204, le ruban 205 ayant une largeur L1 mesurée suivant un axe Ox.

La base 204 comporte les couches suivantes, empilées suivant un axe Oz :

- un substrat semiconducteur 210 en GaAs ;
- une couche tampon 211 en GaAs de 500 nm d'épaisseur ;
- une première partie 212a d'une première couche de confinement optique 212, la première partie 212a s'étendant sur la couche tampon 211.

Le ruban 205 comporte les couches suivantes, empilées suivant l'axe Oz :

- une deuxième partie 212b de la première couche de confinement optique 212 ;

- une couche active 213 s'étendant sur la deuxième partie 212b de la première couche de confinement optique 212 ;
- une deuxième couche de confinement optique 215 s'étendant sur la couche active 212.

La première couche de confinement optique 212 comprend un empilement de 6 bicouches GaAs/GaAlAs.

Dans l'exemple représenté, la première partie 212a de la première couche de confinement optique 212 comprend :

- quatre premières bicouches (non représentées) ;
- une cinquième bicouche 230, identique aux quatre premières bicouches non représentées, comprenant :

  - une première couche 230-1 en GaAs de 147 nm d'épaisseur ;
  - une deuxième couche 230-2 en $Al_{0.6}Ga_{0.4}As$ de 910 nm d'épaisseur ;

- une première couche 231-1 en GaAs de 147 nm d'épaisseur d'une sixième bicouche 231.

La deuxième partie 212b de la première couche de confinement optique 212 comprend une deuxième couche 231-2 en $Al_{0.6}Ga_{0.4}As$ de 910 nm d'épaisseur.

La couche active 213 comprend, dans l'exemple représenté à la figure 4, sept sous-couches :

- une première sous-couche 213-1 en $Al_{0.1}Ga_{0.9}As$ de 30 nm d'épaisseur ;
- une deuxième sous-couche 213-2 de 200 nm d'épaisseur en arséniure de gallium-aluminium, dont la composition varie graduellement et de façon linéaire entre $Al_{0.1}Ga_{0.9}As$ et $Al_{0.3}Ga_{0.7}As$ ;
- une troisième sous-couche 213-3 en $Al_{0.3}Ga_{0.7}As$ de 165 nm d'épaisseur ;
- une quatrième sous-couche 213-4 en GaAs de 12 nm d'épaisseur et comportant un plan de boîtes quantiques 214 en arséniure d'indium InAs émettant au voisinage de 0,95 $\mu$m et jouant le rôle de milieu de gain ;
- une cinquième sous-couche 213-5 en $Al_{0.3}Ga_{0.7}As$ de 13 nm d'épaisseur ;
- une sixième sous-couche 213-6 de 200 nm d'épaisseur en arséniure de gallium-aluminium, dont la composition varie graduellement et de façon linéaire entre $Al_{0.3}Ga_{0.7}As$ et $Al_{0.1}Ga_{0.9}As$ :
- une septième sous-couche 213-7 en $Al_{0.1}Ga_{0.9}As$ de 185 nm d'épaisseur.

La deuxième couche de confinement optique 215 comprend, dans l'exemple représenté à la figure 4, quatre sous-couches :

- une première sous-couche 215-1 de 30 nm d'épaisseur en arséniure de gallium-aluminium, dont la composition varie graduellement et de façon linéaire entre $Al_{0.1}Ga_{0.9}As$ et $Al_{0.8}Ga_{0.2}As$ ;
- une deuxième sous-couche 215-2 en $Al_{0.8}Ga_{0.2}As$ de 1425 nm d'épaisseur ;
- une troisième sous-couche 215-3 de 60 nm d'épaisseur en arséniure de gallium-aluminium dont la composition varie graduellement et de façon linéaire entre $Al_{0.8}Ga_{0.2}As$ et GaAs ;
- une quatrième sous-couche 215-4 en GaAs de 10 nm d'épaisseur.

Les gradualités de composition dans la deuxième sous-couche 213-2 et la sixième sous-couche 213-6 de la couche active 213, ainsi que dans la première sous-couche 215-1 et la troisième sous-couche 215-3 de la deuxième couche de confinement optique 215, facilitent le transport des trous et des électrons dans la structure.

Dans le cadre de la réalisation ultérieure d'une source laser selon l'invention avec un deuxième contact électrique s'étendant sur une partie de la surface supérieure de la base 204, c'est-à-dire dans l'exemple représenté sur une partie de la surface supérieure de la sous-couche 231-1, l'hétérostructure semiconductrice 201 illustrée à la figure 4 présente en outre les niveaux de dopage suivants :

- premier dopage de type N avec une densité de $3.10^{18}$ cm$^{-3}$ sur une épaisseur de 362 nm à partir de la première partie 231-1 de la cinquième bicouche 231 ;
- deuxième dopage de type N avec une densité de $10^{17}$ cm$^{-3}$ sur une épaisseur de 925 nm à partir du premier dopage et s'arrêtant entre les deuxième et troisième sous-couches 213-2 et 213-3 de la couche active 213 ;
- troisième dopage de type P avec une densité de $10^{17}$ cm$^{-3}$ sur une épaisseur de 335 nm s'étendant sur une partie de la sixième sous-couche 213-6 et sur la septième sous-couche 213-7 de la couche active 213 ainsi que sur une partie de la première sous-couche 215-1 de la deuxième couche de confinement optique 215 ;
- quatrième dopage de type P avec une densité de $5.10^{17}$ cm$^{-3}$ sur une épaisseur de 625 nm à partir du troisième dopage ;
- cinquième dopage de type P avec une densité de $2.10^{18}$ cm$^{-3}$ sur une épaisseur de 885 nm à partir du quatrième dopage.

Dans le cadre de la réalisation ultérieure d'une source laser selon l'invention avec un deuxième contact électrique s'étendant sous la surface inférieure de la base 204, il faudrait doper toute la base 204 avec un dopage de type N.

La figure 5 présente des courbes d'accord de phase, calculées pour une génération paramétrique à la dégénérescence, c'est-à-dire pour une onde signal et une onde complémentaire aux pulsations ωs et ωc telles que : ωs = ωc = ωp/2, où ωp est la pulsation de l'onde de pompe.

Le décalage Δn à l'accord de phase est représenté en fonction de la largeur du ruban en abscisse et de la longueur d'onde du faisceau de pompe en ordonnée, avec :

$$\Delta n = 2 * n_p(\omega p) - n_c(\omega c) - n_s(\omega s)$$

Où :

- $n_p(\omega p)$ est l'indice effectif du mode de pompe à la pulsation de pompe ωp ;
- $n_c(\omega c)$ est l'indice effectif du mode complémentaire à la pulsation complémentaire ωc ;
- $n_s(\omega s)$ est l'indice effectif du mode signal à la pulsation signal ωs.

La figure 5 montre que l'accord de phase (Δn = 0) pour un fonctionnement de l'oscillateur paramétrique optique à la dégénérescence et pour une longueur d'onde de pompe de 0,95 μm est obtenu pour une largeur de ruban de 3,25 μm. La figure 5 met en évidence la grande sensibilité de la condition d'accord de phase avec la largeur du ruban. Cette grande sensibilité permettrait, si nécessaire, de corriger des déviations d'une structure par rapport à la structure nominale présentée figure 4.

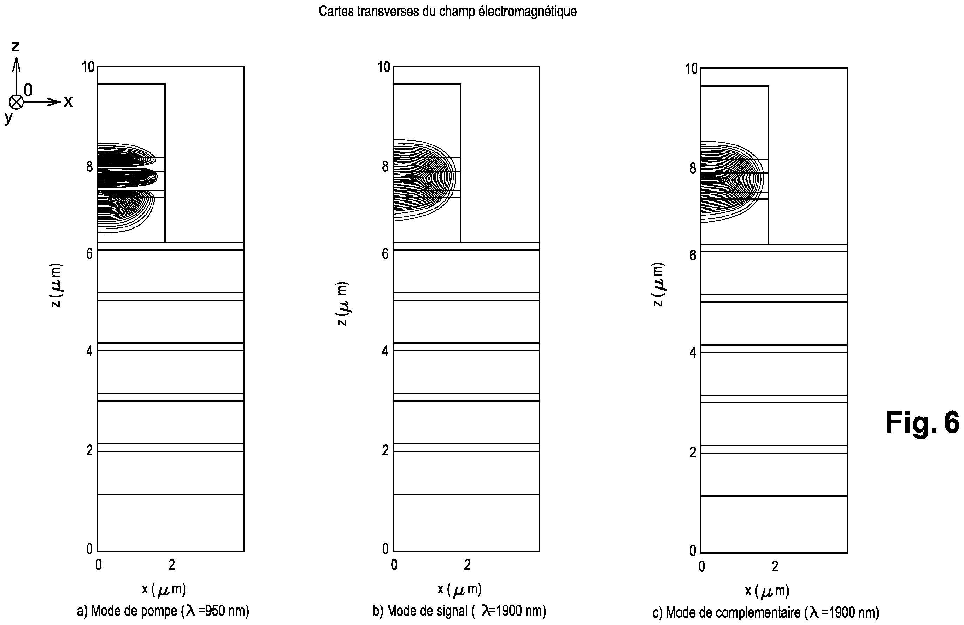

La figure 6 présente les cartes de champ, respectivement associées :

    a) au mode de pompe ;
    b) au mode signal ;
    c) au mode complémentaire.

La figure 6 illustre l'excellent confinement latéral de ces trois modes par un ruban conforme à l'invention. Ces cartes de champ sont aussi caractéristiques d'un confinement par réflexion de Bragg pour le faisceau de pompe, par réflexion totale interne pour les faisceaux signal et complémentaire.

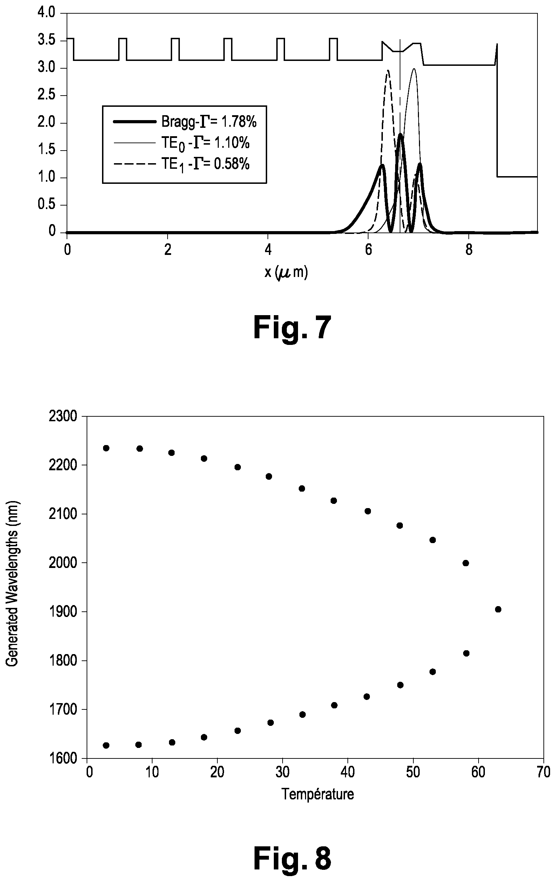

La figure 7 présente le profil d'indice associé à l'hétérostructure présentée figure 4, ainsi que le profil vertical du champ associé aux trois premiers modes guidés de la structure à la longueur d'onde de pompe de 0,95 μm :

- le mode confiné par réflexion de Bragg ;
- les premiers modes guidés de polarisation transverse électrique TE0 et TE1 confinés par réflexion totale interne.

Cette figure confirme que le couplage des boîtes quantiques, dont la position est indiquée par le trait vertical en pointillés, est meilleur pour le mode confiné par réflexion de Bragg. C'est donc bien sur ce mode que la structure va laser au voisinage de 0.95 μm, ce qui est une condition nécessaire pour obtenir l'accord de phase.

Une structure conforme à l'invention peut être de façon générale appliquée à la réalisation d'une source de rayonnement accordable, reposant sur la génération paramétrique de rayonnement à deux pulsations complémentaires, à l'intérieur de la cavité d'une diode laser en fonctionnement, en exploitant les propriétés non-linéaires du matériau semiconducteur constituant le laser. En particulier, les fonctions de laser-OPO, source de photons jumeaux, amplificateur paramétrique optique et translateur de fréquence, décrites précédemment respectivement en lien avec les figures 1a, 1b et 1c, peuvent être réalisées.

La figure 8 illustre l'accordabilité spectrale d'une source paramétrique conforme à l'invention, telle qu'elle peut être obtenue en ajustant la température du composant. On suppose ici que la longueur d'onde de pompe est de 953 nm, ce qui permet d'obtenir un fonctionnement du composant à la dégénérescence pour une température de 63°C. On voit que lorsqu'on varie la température entre 3°C et 63°C, les longueurs d'onde de l'onde signal et de l'onde complémentaire couvrent une très large gamme spectrale, s'étendant de 1620 nm à 2230 nm. On pourra, dans un mode particulier de l'invention, associer sur un même substrat plusieurs sources réalisées avec des largeurs de ruban différentes. Cette approche permet de couvrir une gamme spectrale encore plus grande, en choisissant :

- dans un premier temps, la source que l'on va pomper électriquement, ce qui permet le choix d'une gamme spectrale pour l'onde signal et/ou pour l'onde complémentaire ;
- puis la température, ce qui permet un réglage fin de la longueur d'onde à l'intérieur de la gamme spectrale précédemment choisie.

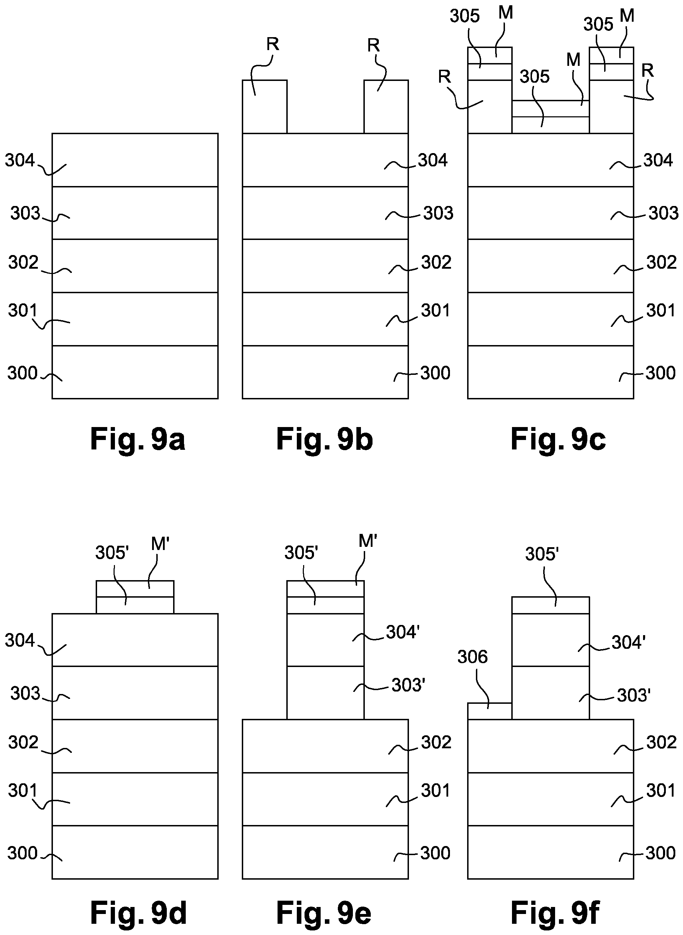

Les figures 9a à 9f illustrent un procédé de fabrication d'une source paramétrique conforme à l'invention. Ce procédé de fabrication débute par la croissance épitaxiale, illustrée à la figure 9a, d'une hétérostructure semiconductrice sur un substrat cristallin 300. Cette hétérostructure comprend, en partant du substrat :

- une couche tampon 301, qui permet de lisser la surface de l'échantillon en début de croissance ;
- une première couche de confinement optique 302, constituée par un empilement périodique de sous-couches formant un réflecteur de Bragg distribué pour le mode de pompe à la pulsation de pompe ωp ;
- une couche active 303 comprenant au moins un plan de boîtes quantiques agissant comme un milieu de gain à la pulsation de pompe ωp, l'indice de réfraction moyen de la couche active étant supérieur à l'indice de réfraction moyen de la première couche de confinement optique ;

- une deuxième couche de confinement optique 304, constituée soit par une couche d'indice de réfraction moyen inférieur à l'indice de réfraction moyen de la couche active, soit par un empilement périodique de sous-couches formant un réflecteur de Bragg distribué pour le mode de pompe à la pulsation de pompe $\omega p$, l'empilement ayant un indice de réfraction moyen inférieur à l'indice de réfraction moyen de la couche active.

Le procédé de fabrication comporte en outre, pendant la croissance :

- une étape de dopage, avec un premier type de dopage, de la première couche de confinement optique 302, au moins dans la ou les sous-couches voisines de la couche active 303 ;
- une étape de dopage, avec un deuxième type de dopage opposé au premier type de dopage, de la deuxième couche de confinement optique 304.

Les étapes ultérieures de fabrication du composant sont calquées sur celles, bien connues de l'homme de l'art, qui sont employées pour la fabrication de diodes laser à ruban gravé. On pourra par exemple suivre le protocole suivant :

- à la figure 9b : dépôt d'une résine R puis lithographie afin de définir des trous dans la résine à la position future du ruban ;
- à la figure 9c : dépôt, sur la résine R et sur la surface de la deuxième couche de confinement optique 304 non recouverte par la résine R, d'une couche métallique 305 et d'une couche de masquage M servant de masque de gravure ;
- à la figure 9d : retrait par « lift-off » de la couche de masquage M et de la couche métallique 305, excepté à la position future du ruban : il reste une couche métallique résiduelle 305' qui va servir à former le premier contact électrique, et un masque de gravure M' ;
- à la figure 9e : définition du ruban par une étape de gravure de la deuxième couche de confinement optique 304 et au moins de la partie de la couche active 303 comprenant le plan de boîtes quantiques. Cette étape est préférentiellement réalisée par gravure sèche, par exemple par gravure ionique réactive, pour avoir un bon contrôle de la largeur du ruban. On obtient un ruban formé par une deuxième couche de confinement optique gravée 304' et une couche active partiellement ou totalement gravée 303'. Le ruban ainsi formé comprend le plan de boîtes quantiques. Alternativement, la première couche de confinement optique 302 peut être également gravée, entièrement ou en partie.
- A la figure 9f : retrait du masque de gravure M' et dépôt d'une couche métallique pour la définition du deuxième contact électrique 306. Si le deuxième contact est un contact latéral, le métal est déposé au pied du ruban gravé sur une sous-couche dopée non gravée, faisant partie de la première couche de confinement optique 302 comme illustré à la figure 9f, ou faisant alternativement partie de la couche tampon 301 dans le cas où la première couche de confinement optique 302 a été entièrement gravée (cas non illustré). L'emplacement de ce deuxième contact 306 est défini par une nouvelle étape de lithographie suivie de lift-off ;

- recuit thermique de l'échantillon pour activer les deux contacts électriques et en obtenir un bon comportement ohmique ;
- définition des facettes de sortie, par exemple par clivage, une autre option consistant à les définir par gravure en même temps que le ruban ;
- dépôt éventuel de miroirs ou couches de faible réflectivité sur les facettes de sortie ;
- installation du composant sur une embase et prise de contact électrique par des fils d'amenée de courant.

Dans la présente description, nous avons ciblé préférentiellement la génération de rayonnement dans l'infrarouge, dans une gamme de longueur d'onde comprise entre 1 $\mu$m et 3 $\mu$m. Cependant, une structure conforme à l'invention peut être envisagée dans d'autres domaines spectraux. A titre d'exemple, on pourrait réaliser la génération paramétrique de deux faisceaux de lumière visible par génération paramétrique au sein d'une diode laser à base de nitrure de gallium GaN, dont le faisceau de pompe serait dans le proche UV, le bleu ou le vert. La génération paramétrique au sein d'une diode laser à base de phosphure d'indium InP, dont la longueur d'onde du faisceau de pompe serait comprise entre 1,3 $\mu$m et 2 $\mu$m, est également envisageable.

## Revendications

1. Source laser (100, 100') accordable pompée électriquement comportant :

   - une première couche de confinement optique (112, 212) s'étendant suivant un plan de référence Oxy et formant un réflecteur de Bragg distribué pour une onde de pompe à une longueur d'onde de pompe ;
   - une couche active (113, 213) en matériau semiconducteur non linéaire s'étendant sur la première couche de confinement optique (112, 212), l'indice de réfraction moyen de la couche active (113, 213) étant supérieur à l'indice de réfraction moyen de la première couche de confinement optique (112, 212) ;
   - une deuxième couche de confinement optique (115, 215) s'étendant sur la couche active (113, 213), l'indice de réfraction moyen de la deuxième couche de confinement optique (115, 215) étant inférieur à l'indice de réfraction moyen de la couche active (113, 213) ;

ladite source laser (100, 100') comportant :

- une base (104, 204) ayant une première largeur suivant un axe Ox ;
- un ruban (105, 205) s'étendant sur la base (104, 204), ledit ruban (105, 205) ayant une deuxième largeur (L1) suivant un axe Ox inférieure à ladite première largeur ;

ladite source laser (100, 100') étant **caractérisée en ce que** :

- la deuxième largeur (L1) est inférieure à 10 $\mu$m ;
- la couche active (113, 213) comprend au moins un plan de boîtes quantiques (114, 214) aptes à émettre une onde de pompe à une longueur d'onde de pompe ;
- le ruban (105, 205) comporte au moins :

    • la partie de la couche active (113, 213) comprenant le plan de boîtes quantiques (114, 214) ;
    • la deuxième couche de confinement optique (115, 215) ;

    ledit ruban (105, 205) permettant l'émission, par conversion paramétrique à partir de l'onde de pompe, de deux ondes, dites respectivement « onde signal » et « onde complémentaire », la deuxième largeur (L1) étant choisie pour assurer l'accord de phase entre l'onde de pompe, l'onde signal et l'onde complémentaire.

2. Source laser (100, 100') selon la revendication précédente **caractérisée en ce que**, dans le plan de boîtes quantiques (114, 214), la densité des boîtes quantiques est comprise entre 1 boîte/$\mu$m$^2$ et 1000 boîtes/$\mu$m$^2$, et préférentiellement entre 100 boîtes/$\mu$m$^2$ et 1000 boîtes/$\mu$m$^2$.

3. Source laser (100, 100') selon l'une quelconque des revendications précédentes **caractérisée en ce que** le ruban (105, 205) comporte toute la couche active (113, 213).

4. Source laser (100, 100') selon l'une quelconque des revendications précédentes **caractérisée en ce que** le ruban (105, 205) comporte en outre une deuxième partie (112b, 212b) de la première couche de confinement optique (112, 212).

5. Source laser (100, 100') selon l'une quelconque des revendications précédentes **caractérisée en ce que** la source laser (100, 100') a une longueur (L2) suivant un axe Oy perpendiculaire à l'axe Ox comprise entre 100 $\mu$m et 5 mm.

6. Source laser (100, 100') selon l'une quelconque des revendications précédentes **caractérisée en ce que** la deuxième couche de confinement optique (115, 215) forme un réflecteur de Bragg distribué pour l'onde de pompe à la longueur d'onde de pompe.

7. Source laser (100, 100') selon l'une quelconque des revendications précédentes **caractérisée en ce que** le ruban (105, 205) comporte un premier miroir diélectrique sur sa première facette de sortie (120-1) et un deuxième miroir diélectrique sur sa deuxième facette de sortie (120-2) afin d'assurer la réflexion de l'onde signal et/ou de l'onde complémentaire et/ou de l'onde de pompe.

8. Source laser (100, 100') selon l'une quelconque des revendications 1 à 6 **caractérisée en ce que** le ruban (105, 205) comporte, pour l'onde signal et l'onde complémentaire, une couche optique de faible réflectivité sur sa première facette de sortie (120-1) et une couche optique de haute réflectivité sur sa deuxième facette de sortie (120-2).

9. Source laser (100, 100') selon l'une quelconque des revendications précédentes dans laquelle :

    - la base (104, 204) comporte une face supérieure sur laquelle repose le ruban (105, 205),
    - le ruban (105, 205) comporte une face inférieure au contact de la face supérieure de la base (104, 204) et une face supérieure ;

    la source laser (100, 100') étant **caractérisée en ce qu'**elle comporte :

    - un premier contact (103) placé sur la face supérieure du ruban (105, 205) ;
    - un deuxième contact (102-1) placé sur une partie de la face supérieure de la base (104, 204).

10. Source laser (100, 100') selon l'une quelconque des revendications 1 à 8 dans laquelle :

    - la base (104, 204) comporte une face supérieure, sur laquelle repose le ruban (105, 205), et une face inférieure,
    - le ruban (105, 205) comporte une face inférieure au contact de la face supérieure de la base (104, 204) et une face supérieure ;

    la source laser (100, 100') étant **caractérisée en ce qu'**elle comporte :

- un premier contact (103) placé sur la face supérieure du ruban (105, 205) ;
- un deuxième contact (102-2) placé sur la face inférieure de la base (104, 204).

11. Source laser (100, 100') selon l'une quelconque des revendications précédentes **caractérisée en ce qu'**elle repose sur une embase permettant de contrôler sa température.

12. Source laser (100, 100') selon l'une quelconque des revendications précédentes **caractérisée en ce qu'**elle émet un rayonnement dans une gamme de longueur d'onde comprise entre 1 $\mu$m et 3 $\mu$m.

13. Source laser (100, 100') selon la revendication précédente **caractérisée en ce que** l'onde de pompe est émise par une couche active (113, 213) en GaAs comportant au moins un plan de boîtes quantiques d'InAs (114, 214).

14. Procédé de fabrication d'une source laser (100, 100') selon l'une quelconque des revendications précédentes **caractérisé en ce qu'**il comporte les étapes suivantes :

- croissance épitaxiale sur un substrat (300) s'étendant suivant un plan de référence Oxy d'une hétérostructure semiconductrice comportant au moins les couches suivantes dans cet ordre à partir du substrat :

  • une couche tampon (301) ;
  • une première couche de confinement optique (302) formant un réflecteur de Bragg distribué pour une onde de pompe à une longueur d'onde de pompe ;
  • une couche active (303) en matériau semiconducteur optiquement non linéaire, l'indice de réfraction moyen de la couche active (303) étant supérieur à l'indice de réfraction moyen de la première couche de confinement optique (302), ladite couche active (303) comportant au moins un plan de boîtes quantiques aptes à émettre l'onde de pompe à la longueur d'onde de pompe ;
  • une deuxième couche de confinement optique (304), l'indice de réfraction moyen de la deuxième couche de confinement optique (304) étant inférieur à l'indice de réfraction moyen de la couche active (303) ;

- gravure, suivant une direction Oz dans l'hétérostructure semiconductrice, au moins dans la deuxième couche de confinement optique (304) et dans la partie de la couche active (303) comprenant le plan de boîtes quantiques, d'un ruban, ledit ruban ayant une largeur inférieure à

10 $\mu$m.

**Patentansprüche**

1. Elektrisch gepumpte, einstellbare Laserquelle (100, 100'), umfassend:

- eine erste optische Einschlussschicht (112, 212), die sich gemäß einer Referenzebene Oxy erstreckt und einen verteilten Bragg-Spiegel für eine Pumpwelle mit einer Pumpwellenlänge bildet;
- eine aktive Schicht (113, 213) aus nicht linearem Halbleitermaterial, das sich auf der ersten optischen Einschlussschicht (112, 212) erstreckt; wobei der durchschnittliche Brechungsindex der aktiven Schicht (113, 213) größer ist als der durchschnittliche Brechungsindex der ersten optischen Einschlussschicht (112, 212);
- eine zweite optische Einschlusssicht (115, 215), die sich auf der aktiven Schicht (113, 213) erstreckt, wobei der durchschnittliche Brechungsindex der zweiten optischen Einschlussschicht (115, 215) kleiner ist als der durchschnittliche Brechungsindex der aktiven Schicht (113, 213);

wobei die genannte Laserquelle (100, 100') umfasst:

- eine Basis (104, 204), die eine erste Breite gemäß einer Achse Ox hat;
- ein Band (105, 205), das sich auf der Basis (104, 204) erstreckt, wobei das genannte Band (105, 205) eine zweite Breite (L1) gemäß einer Achse Ox hat, die kleiner ist als die genannte erste Breite;

wobei die genannte Laserquelle (100, 100') **dadurch gekennzeichnet ist, dass**:

- die zweite Breite (L1) kleiner ist als 10 $\mu$m;
- die aktive Schicht (113, 213) wenigstens eine Quantenpunktebene (114, 214) umfasst, die geeignet ist, eine Pumpwelle mit einer Pumpwellenlänge auszugeben;
- das Band (105, 205) wenigstens umfasst:

  • den Teil der aktiven Schicht (113, 213), umfassend die Quantenpunktebene (114, 214);
  • die zweite optische Einschlussschicht (115, 215);

wobei das genannte Band (105, 205) die Ausgabe von zwei Wellen, jeweils bezeichnet als "Signalwelle" und "komplementäre Welle" per parametrischer Konvertierung ausgehend von der Pumpwelle zulässt, wobei die zweite Breite (L1) ausgewählt ist, um die Phasenabstimmung zwischen der Pumpwelle, der Signalwelle und der komplementären Welle zu gewährleisten

2. Laserquelle (100, 100') gemäß dem voranstehenden Anspruch, **dadurch gekennzeichnet, dass** die Dichte der Quantenpunkte in der Quantenpunktebene (114, 214) zwischen 1 Punkt/$\mu$m$^2$ und 1000 Punkten/$\mu$m$^2$ und bevorzugt zwischen 100 Punkten/$\mu$m$^2$ und 1000 Punkten/$\mu$m$^2$ inbegriffen ist.

3. Laserquelle (100, 100') gemäß irgendeinem der voranstehenden Ansprüche, **dadurch gekennzeichnet, dass** das Band (105, 205) die ganze aktive Schicht (113, 213) umfasst.

4. Laserquelle (100, 100') gemäß irgendeinem der voranstehenden Ansprüche, **dadurch gekennzeichnet, dass** das Band (105, 205) darüber hinaus einen zweiten Teil (112b, 212b) der ersten optischen Einschlussschicht (112, 212) umfasst.

5. Laserquelle (100, 100') gemäß irgendeinem der voranstehenden Ansprüche, **dadurch gekennzeichnet, dass** die Laserquelle (100, 100') eine zwischen 100 $\mu$m und 5 mm inbegriffene Länge (L2) gemäß einer zur Achse Ox lotrechten Achse Oy hat.

6. Laserquelle (100, 100') gemäß irgendeinem der voranstehenden Ansprüche, **dadurch gekennzeichnet, dass** die zweite optische Einschlussschicht (115, 215) einen verteilten Bragg-Spiegel für die Pumpwelle mit der Pumpwellenlänge hat.

7. Laserquelle (100, 100') gemäß irgendeinem der voranstehenden Ansprüche, **dadurch gekennzeichnet, dass** das Band (105, 205) einen ersten dielektrischen Spiegel auf seiner ersten Ausgangsfacette (102-1) und einen zweiten dielektrischen Spiegel auf seiner zweiten Ausgangsfacette (102-2) umfasst, um das Reflektieren der Signalwelle und/oder komplementären Welle und / oder der Pumpwelle zu gewährleisten.

8. Laserquelle (100, 100') gemäß irgendeinem der Ansprüche 1 bis 6, **dadurch gekennzeichnet, dass** das Band (105, 205) für die Signalwelle und die komplementäre Welle eine optische Schicht mit geringer Reflektivität auf ihrer ersten Ausgangsfacette (120-1) und eine optische Schicht mit hoher Reflektivität auf ihrer zweiten Ausgangsfacette (120-2) umfasst.

9. Laserquelle (100, 100') gemäß irgendeinem der voranstehenden Ansprüche, bei der:

   - die Basis (104, 204) eine obere Seite umfasst, auf der das Band (105, 205) beruht;
   - das Band (105, 205) eine untere Seite mit Kontakt zur oberen Seite der Basis (104, 204) und eine obere Seite umfasst;

wobei die Laserquelle (100, 100') **dadurch gekennzeichnet ist, dass** sie umfasst:

   - einen ersten Kontakt (103), der auf der oberen Seite des Bandes (105, 205) platziert ist;
   - einen zweiten Kontakt (102-1), der auf einem Teil der oberen Seite der Basis (104, 204) platziert ist.

10. Laserquelle (100, 100') gemäß irgendeinem der Ansprüche 1 bis 8, bei der:

   - die Basis (104, 204) eine obere Seite umfasst, auf der das Band (105, 205) beruht, und eine untere Seite,
   - das Band (105, 205) eine untere Seite mit Kontakt zu der oberen Seite der Basis (104, 204) und eine obere Seite umfasst;

wobei die Laserquelle **dadurch gekennzeichnet ist, dass** sie umfasst:

   - einen ersten Kontakt (103), der auf der oberen Seite des Bandes (105, 205) platziert ist;
   - einen zweiten Kontakt (102-2), der auf der unteren Seite der Basis (104, 204) platziert ist.

11. Laserquelle (100, 100') gemäß irgendeinem der voranstehenden Ansprüche, **dadurch gekennzeichnet, dass** sie auf einem Sockel beruht, der die Kontrolle ihrer Temperatur zulässt.

12. Laserquelle (100, 100') gemäß irgendeinem der voranstehenden Ansprüche, **dadurch gekennzeichnet, dass** sie eine Strahlung in einem zwischen 1 $\mu$m und 3 $\mu$m inbegriffenen Wellenlängenbereich ausgibt.

13. Laserquelle (100, 100') gemäß dem voranstehenden Anspruch, **dadurch gekennzeichnet, dass** die Pumpwelle durch eine aktive Schicht (113, 213) in GaAs ausgegeben wird, die wenigstens eine InAs Quantenpunktebene (114, 214) umfasst.

14. Herstellungsverfahren einer Laserquelle (100, 100') gemäß irgendeinem der voranstehenden Ansprüche, **dadurch gekennzeichnet, dass** es die folgenden Schritte umfasst:

   - epitaxiales Wachstum auf einem Substrat (300), das sich gemäß einer Referenzebene Oxy einer Halbleiter-Heterostruktur erstreckt, die wenigstens die folgenden Schichten in dieser Reihenfolge ausgehend von dem Substrat umfasst:

• eine Pufferschicht (301);
• eine erste optische Einschlussschicht (302), die einen verteilten Bragg-Spiegel für eine Pumpwelle mit einer Pumpwellenlänge bildet;
• eine aktive Schicht (303) aus optisch nicht linearem Halbleitermaterial, wobei der durchschnittliche Brechungsindex der aktiven Schicht (303) größer ist als der durchschnittliche Brechungsindex der ersten optischen Einschlussschicht (302), wobei die genannte aktive Schicht (303) wenigstens eine Quantenpunktebene umfasst, die geeignet ist, die Pumpwelle mit der Pumpwellenlänge auszugeben;
• eine zweite optische Einschlussschicht (304), wobei der durchschnittliche Brechungsindex der zweiten optischen Einschlussschicht (304) kleiner ist als der durchschnittliche Brechungsindex der aktiven Schicht (303);

- Gravieren eines Bandes gemäß einer Richtung Oz in der Halbleiter-Heterostruktur wenigstens in der zweiten optischen Einschlussschicht (304) und in dem Teil der aktiven Schicht (303), die die Quantenpunktebene umfasst, wobei das genannte Band eine Breite von weniger als 10 $\mu$m hat.

## Claims

1. An electrically pumped tuneable laser source (100, 100') comprising:

- a first optical confinement layer (112, 212) extending along an Oxy reference plane and forming a distributed Bragg reflector for a pump wave at a pump wavelength;
- an active layer (113, 213) made of non-linear semiconducting material extending on the first optical confinement layer (112, 212), the average refraction index of the active layer (113, 213) being greater than the average refraction index of the first optical confinement layer (112, 212);
- a second optical confinement layer (115, 215) extending on the active layer (113, 213), the average refraction index of the second optical confinement layer (115, 215) being less than the average refraction index of the active layer (113, 213);

said laser source (100, 100') comprising:

- a base (104, 204) with a first width along an Ox axis;
- a ribbon (105, 205) extending on the base (104, 204), said ribbon (105, 205) having a second width (L1) along an Ox axis less than said first width;

said laser source (100, 100') being **characterised in that**:

- the second width (L1) is less than 10 $\mu$m;
- the active layer (113, 213) comprises at least one plane of quantum boxes (114, 214) capable of emitting a pump wave at a pump wavelength;
- the ribbon (105, 205) comprises at least:

• the part of the active layer (113, 213) comprising the quantum boxes plane (114, 214);
• the second optical confinement layer (115, 215);

said ribbon (105, 205) enabling emission, by parametric conversion from the pump wave, of two waves, respectively called the "signal wave" and the "complementary wave", , the second width (L1) being chosen to match the phase between the pump wave, the signal wave and the complementary wave.

2. The laser source (100, 100') according to the previous claim, **characterised in that** in the quantum boxes plane (114, 214), the density of quantum boxes is between 1 box/$\mu$m$^2$ and 1000 boxes/$\mu$m$^2$, and preferably between 100 boxes/$\mu$m$^2$ and 1000 boxes/$\mu$m$^2$.

3. The laser source (100, 100') according to any one of the previous claims, **characterised in that** the ribbon (105, 205) comprises the entire active layer (113, 213).

4. The laser source (100, 100') according to any one of the previous claims, **characterised in that** the ribbon (105, 205) also comprises a second part (112b, 212b) of the first optical confinement layer (112, 212).

5. The laser source (100, 100') according to any one of the previous claims, **characterised in that** the laser source (100, 100') has a length (L2) along an Oy axis perpendicular to the Ox axis that is between 100 $\mu$m and 5 mm.

6. The laser source (100, 100') according to any one of the previous claims, **characterised in that** the second optical confinement layer (115, 215) forms a distributed Bragg reflector for the pump wave at the pump wavelength.

7. The laser source (100, 100') according to any one of the previous claims, **characterised in that** the ribbon (105, 205) comprises a first dielectric mirror on its first output facet (120-1) and a second dielectric mirror on its second output facet (120-2) in order to reflect the signal wave and/or the complementary wave and/or the pump wave.

8. The laser source (100, 100') according to any one of claims 1 to 6, **characterised in that** the ribbon (105, 205) comprises, for the signal wave and the complementary wave, an optical layer with low reflectivity on its first output facet (120-1) and an optical layer with high reflectivity on its second output facet (120-2).

9. The laser source (100, 100') according to any one of the previous claims in which:

    - the base (104, 204) comprises a top face on which the ribbon (105, 205) is supported,
    - the ribbon (105, 205) comprises a bottom face in contact with the top face of the base (104, 204) and a top face;

    the laser source (100, 100') being **characterised in that** it comprises:

    - a first contact (103) placed on the top face of the ribbon (105, 205);
    - a second contact (102-1) placed on part of the top face of the base (104, 204).

10. The laser source (100, 100') according to any one of claims 1 to 8 in which:

    - the base (104, 204) comprises a top face on which the ribbon (105, 205) is supported, and a bottom face,
    - the ribbon (105, 205) comprises a bottom face in contact with the top face of the base (104, 204) and a top face;

    the laser source (100, 100') being **characterised in that** it comprises:

    - a first contact (103) placed on the top face of the ribbon (105, 205);
    - a second contact (102-2) placed on the bottom face of the base (104, 204).

11. The laser source (100, 100') according to any one of the previous claims, **characterised in that** it is supported on a base that is used to control its temperature.

12. The laser source (100, 100') according to any one of the previous claims, **characterised in that** it emits radiation in a wavelength range between 1 μm and 3 μm.

13. The laser source (100, 100') according to the previous claim, **characterised in that** the pump wave is emitted by a GaAs active layer (113, 213) comprising at least one plane of InAs quantum boxes (114, 214).

14. A process for fabrication of a laser source (100, 100') according to any one of the previous claims, **characterised in that** it comprises the following steps:

    - epitaxial growth on a substrate (300) extending along an Oxy reference plane of a semiconductor heterostructure comprising at least the following layers in this order starting from the substrate:

        • a buffer layer (301);
        • a first optical confinement layer (302) forming a distributed Bragg reflector for a pump wave at a pump wavelength;
        • an active layer (303) made of optically nonlinear semiconducting material, the average refraction index of the active layer (303) being greater than the average refraction index of the first optical confinement layer (302), said active layer (303) comprising at least one plane of quantum boxes capable of emitting the pump wave at the pump wavelength;
        • a second optical confinement layer (304), the average refraction index of the second optical confinement layer (304) being less than the average refraction index of the active layer (303);

    - etching of a ribbon along an Oz direction in the semiconductor heterostructure, at least in the second optical confinement layer (304) and in the part of the active layer (303) comprising the quantum boxes plane, the width of said ribbon being less than 10 μm.

**Fig. 1a**

**Fig. 1b**

**Fig. 1c**

**Fig. 2**

**Fig. 3a**

**Fig. 3b**

Fig. 4

Courbes d'accord de phase
Δ n

Fig. 5

Cartes transverses du champ électromagnétique

a) Mode de pompe (λ =950 nm)

b) Mode de signal ( λ=1900 nm)

c) Mode de complementaire (λ =1900 nm)

Fig. 6

EP 2 804 271 B1

**Fig. 7**

**Fig. 8**

**Fig. 9a**

**Fig. 9b**

**Fig. 9c**

**Fig. 9d**

**Fig. 9e**

**Fig. 9f**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20070104443 A

**Littérature non-brevet citée dans la description**

- **C.TONG.** Characteristics of Edge-Emitting Bragg Reflection Waveguide Lasers. *IEEE Journal of Quantum Electronics,* 01 Novembre 2010, vol. 46 (11), 1605-1610

- **P. ABOLGHASEM.** Single-sided Bragg reflection waveguides with multilayer core for monolithic semiconductor parametric devices. *Journal of the optical society of America B,* 01 Juin 2012, vol. 29 (6), 1367
- **B. J. BILJANI et al.** *actes de la conférence CLEO 2011*